(19) Europäisches Patentamt
European Patent Office
Office européen des brevets

(11) EP 4 375 002 A1

(12) EUROPEAN PATENT APPLICATION
published in accordance with Art. 153(4) EPC

(43) Date of publication:
29.05.2024 Bulletin 2024/22

(51) International Patent Classification (IPC):
B23K 26/00 (2014.01)

(21) Application number: 21950909.8

(52) Cooperative Patent Classification (CPC):
B23K 26/00; B23K 26/064; B23K 26/082;
B23K 26/57; G02B 26/10; H01L 21/50; H01S 3/00

(22) Date of filing: 20.07.2021

(86) International application number:
PCT/JP2021/027082

(87) International publication number:
WO 2023/002555 (26.01.2023 Gazette 2023/04)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(71) Applicant: SHIN-ETSU CHEMICAL CO., LTD.
Tokyo 1000005 (JP)

(72) Inventors:
• YAMAOKA, Hiroshi
  Tokyo 103-8577 (JP)
• NAKADA, Satoki
  Tokyo 103-8577 (JP)
• USAMI, Taketo
  Tokyo 136-8580 (JP)

(74) Representative: Meissner Bolte Partnerschaft
mbB
Widenmayerstraße 47
80538 München (DE)

(54) **SCANNING-TYPE REDUCTION PROJECTION OPTICAL SYSTEM AND LASER MACHINING APPARATUS USING SAME**

(57) In the present invention, micro devices on a donor substrate are subjected to LIFT onto an opposed receptor substrate with high position accuracy by a scanning reduced projection optical system that forms an image of traverse multimode pulsed laser light with a minute area size onto the donor substrate through a lens array-type zoom homogenizer, an array mask 10, a scanning mirror 4, a photomask 6, and a telecentric projection lens 8. An implementation method thereof includes steps of inspection for acquiring position information, LIFT area division, irradiation position selection, transfer, and stage moving. This configuration can provide a scanning reduced projection optical system capable of scanning a minute irradiation area having a uniform and invariable energy distribution over a wide range with high accuracy and high speed while compensating for scanner accuracy deficiencies, without using expensive fθ lenses or telecentric reduced projection lenses with large apertures, as well as a LIFT apparatus for mounting or retransfer equipped with the scanning reduced projection optical system at low costs, and an implementation method thereof.

[FIG. 6B]

**Description**

TECHNICAL FIELD

The present invention relates to a scanning reduced projection optical system and a laser processing apparatus using the same.

BACKGROUND ART

Technologies for use in manufacturing processes of displays and others include a technique that involves transferring a large number of micro devices such as micro LEDs arranged in a matrix on a donor substrate to receptor substrate. Another technique involves transferring a variety of conductive or adhesive functional film, a material film, or an organic EL film applied on a donor substrate to a receptor substrate. There are various techniques including laser induced forward transfer (LIFT), stamping, and roll transfer. Unfortunately, in any of these techniques, it is not easy to achieve both high speed processing and high position accuracy, which are required in their processes. Even when high speed is achieved, mistransfer or misalignment may occur.

CITATION LIST

PATENT LITERATURE

Patent Document 1: JP 2020-4478 A
Patent Document 2: JP 2006-41500 A

SUMMARY OF INVENTION

TECHNICAL PROBLEM

The applicant has developed a fast and accurate LIFT apparatus (Patent Document 1). However, the micro devices and the like on the donor substrate or the receptor substrate, which are transferred and mounted by a transfer apparatus using the stamping or roll transfer technique for use in a LIFT apparatus, sometimes have defects which may account for 1%. The technique for retransferring micro devices and the like to defective sections and apparatuses using the technique are also requested to achieve both higher accuracy and higher speed.

Such technique can be used not only for retransfer from a donor substrate to a receptor substrate but also for removing irradiation targets such as defective micro devices or unnecessary material portions on the substrate, and is expected to be used in a mounting process of transferring micro devices and the like as well as in a defective removing process.

On the other hand, there is an accurate transfer technique using a step-and-repeat method, unlike Patent Document 1. For example, in the technique of retransferring micro devices and the like again to no-device sections in which defective micro devices and the like on a substrate to be corrected have been removed in advance, excimer laser light is shaped into laser light having a uniform energy distribution, by using a beam homogenizer including a combination of lens arrays, and by using a photomask and a reduced projection lens, this laser light is reduced and projected toward micro devices and the like on a donor substrate (for retransfer) to perform LIFT of the micro devices and the like onto the substrate to be corrected. By using a stage having high position accuracy, this technique can accurately perform LIFT (retransfer) of micro devices and the like on the donor substrate onto the substrate to be corrected. However, this technique takes a processing time of one or two seconds per micro device and therefore may be impracticable in terms of production efficiency, when used in a retransfer apparatus in the manufacturing process of displays and the like in which a large amount of defective sections that account for 1% may occur.

As a technique that can achieve higher speed, there is a well-known technique using an optical system including a combination of a galvano scanner and an fθ lens to scan laser light at high speed and irradiate irradiation targets with the laser light. This technique can remove defective micro devices and the like at high speed from the substrate to be corrected to the extent that the position accuracy by the scanner is permitted, but has difficulty due to limited accuracy, in the subsequent retransfer which requires high position accuracy.

In order to solve the issue related to position accuracy by the scanner, a scanning reduced projection optical system with high speed and high position accuracy can be constructed, in which scanned laser light is selectively emitted toward openings arrayed on a photomask, through an fθ lens and the like, and the laser light is reduced and projected onto predetermined irradiation targets on a substrate, whereby the dependency on the scanning accuracy of the scanner is decreased. Patent Document 2 discloses an example of an optical system that scans a beam of Nd:YAG laser by virtue of a galvano mirror and reduces and projects the beam through an fθ lens and photomask, thereby compensating for misalignment of an irradiation area on a donor substrate due to low scanning accuracy.

However, for larger substrates and even faster processing, it is necessary to take a larger irradiation area on the donor substrate, and reduce and project the scanned laser light onto many irradiation targets in a short time. In other words, it is necessary to take a large irradiation area that can be scanned on a photomask. In this case, the aperture of the fθ lens and/or the reduced projection lens in Patent Document 2 need to be increased, and constructing a telecentric design costs much.

Moreover, in order to cope with miniaturization and high density of irradiation targets such as micro devices, in addition to compensation for accuracy limitations of the scanner, laser light that has an extremely small irradiation area size with a stable and uniform intensity distribution so as not to interfere with adjacent irradiation targets is necessary on a donor substrate. In addition, a LIFT apparatus, a retransfer apparatus, and a defective-removing apparatus that are equipped with such an optical system to substitute the apparatus in Patent Document 1 are expected to be provided.

An object is to provide a scanning reduced projection optical system capable of scanning a minute irradiation area having a uniform and invariable energy distribution over a wide range and at high accuracy and high speed while compensating for accuracy deficiencies of the scanner, without using expensive fθ lenses or telecentric reduced projection lenses with large apertures, as well as a LIFT apparatus for mounting or retransfer equipped with the scanning reduced projection optical system at low costs, and an implementation method using these apparatuses.

SOLUTION TO PROBLEM

A first aspect of the invention provides a scanning reduced projection optical system that can be used in a laser processing apparatus that uses emitting multimode pulsed laser light toward irradiation targets, such as micro devices such as mini LEDs or micro LEDs arrayed on a substrate, or a material film or a functional film applied or printed on a substrate, to induce a reaction directly in the irradiation targets or through a substance between the substrate and the irradiation targets, wherein the scanning reduced projection optical system includes, as its constituent optical devices, a lens array-type zoom homogenizer, a scanning mirror scanned by a drive axis controller with one or more axes, a photomask, and a projection lens system that is telecentric at least on the image side, and the photomask has openings arrayed with a predetermined pitch, each opening having a predetermined shape to be reduced and projected.

The homogenizer includes a first lens array and a second lens array, and a condenser lens. The second lens array and the condenser lens constitute an infinity-corrected optical system. The zoom homogenizer forms an image of an irradiation area onto the photomask and compensates for variations in particular in position and size of the irradiation area and in energy intensity distribution in the irradiation area, the irradiation area having a predetermined size that covers an opening group having one or more openings adjacent to each other on the photomask.

For example, it is known that variations in oscillation state cause variations in beam pointing stability or beam size of laser light and in intensity distribution of a beam cross section. As used herein "compensate for variations" refer to a state in which the zoom homogenizer avoids influences of the variations in the irradiation area imaged on the photomask. As a result, an image of a minute area having an extremely uniform energy distribution can be formed on a donor substrate on which the mask is projected.

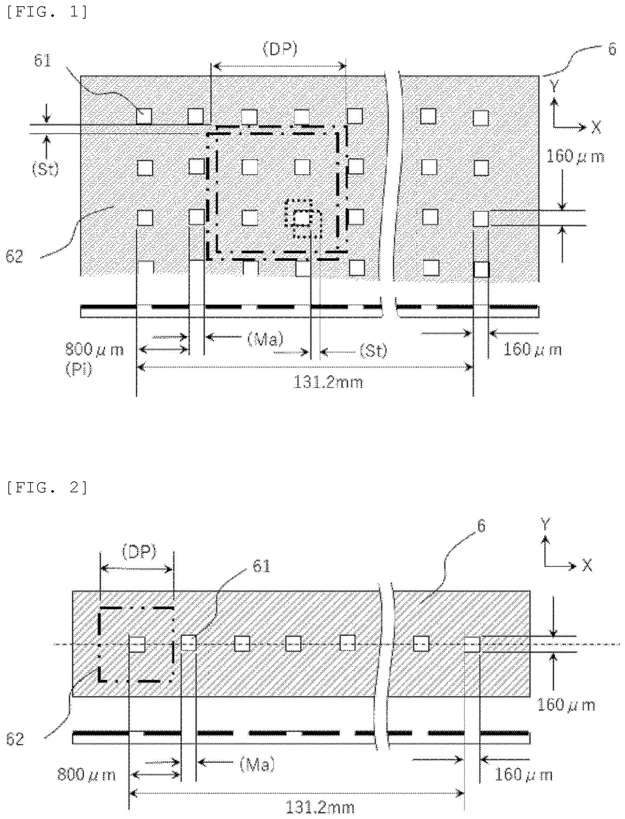

The predetermined size is a size with which the irradiation area does not extend to any other openings adjacent to the periphery of the opening group. In other words, in consideration of the accuracy in irradiation position on the photomask that is associated with the scanning accuracy of the scanning mirror, the predetermined size is a size with which the boundary (outer edge) of the energy distribution equal to or greater than a threshold that would induce a reaction if laser light passed through an adjacent opening and irradiated an irradiation target (not intended to be irradiated) on the substrate does not extend to (overlap) any of the openings adjacent to the opening group contained in the irradiation area. As an example, in FIG. 1, an irradiation area (DP) surrounded by a dashed-dotted line illustrates the allowable maximum size of the irradiation area that covers an opening group having four openings (61), and a small irradiation area surrounded by a dotted line illustrates the minimum size of the irradiation area that covers one opening. In the drawing, the examples of both irradiation areas are illustrated double in order to represent a deviation due to position accuracy of the scanner.

For example, as depicted in FIG. 1, in a case where openings (squares) are arrayed in a matrix on a photomask (6), letting one side of each opening be Ma, the pitch be Pi, and the scanning position accuracy on the photomask by the scanner be St, one side (DP) of a predetermined size of an irradiation area (square) to collectively irradiate n×n (n≥1) openings is within a predetermined range represented by the following expression.

$$Pi \times (n-1) + Ma + St \leq DP < Pi \times (n+1) - Ma - St$$

When the predetermined size exceeds this range, laser light having energy exceeding the above threshold and having that passed through the unintended (part of) adjacent opening may be reduced and projected onto an irradiation target unintended as well to induce a reaction. The shape of the openings that is not square and the range of the predetermined size (DP) in collective irradiation of n×m openings are a matter of design choice.

When a photomask having openings arrayed in a matrix is used for collective irradiation, the pitch (Pi) of the openings on the photomask is fixed to c times the pitch of irradiation targets to be subjected to LIFT onto a receptor substrate, where the magnification of a reduced projection lens is 1/c X.

Depending on the specifications of the reduced projection lens, the number of openings can be selected from various designs including an array of a row in FIG. 2 and an array of a matrix in FIG. 1 as described above. These also depend on the range that can be scanned by the scanning mirror.

Lens elements included in the first lens array and the second lens array are not limited to a fly eye type and may be of a cylindrical type or a spherical type. Thus, each lens array may be a combination of lens elements orthogonal to each other. Further, a third lens array may be added to the zoom homogenizer.

According to a second aspect, in the scanning reduced projection optical system according to the first aspect, the projection lens system includes a field lens provided between the condenser lens and the photomask, and a reduced projection lens that is telecentric at least on the image side.

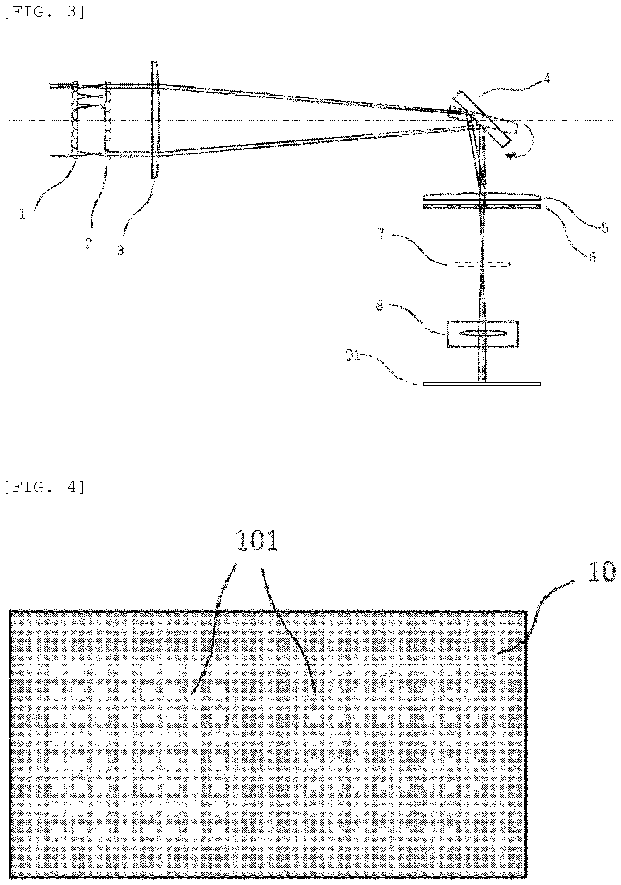

Here, the specifications of the field lens are determined based on the specifications of the zoom homogenizer, the condenser lens (3), and the telecentric lens, and in the present invention, the field lens is preferably located immediately before the photomask (6) as depicted in FIG. 3. The focal length of the field lens (5) is designed with a curvature that enables laser light from the zoom homogenizer (light condensing points as many as the number of lens elements of the second lens array (2)) to pass through a diaphragm (7) placed at the entrance pupil position of the image-side telecentric reduced projection lens (8).

According to a third aspect, in the scanning reduced projection optical system according to the first or second aspect, the scanning mirror (4) includes a two-axis galvano scanner. With this configuration, an irradiation area of laser light can be scanned toward the openings arrayed in multiple rows on the photomask (6). Various controllers such as a dedicated controller and a combination of a dedicated board and a PC can be employed for the scanning mirror. In any case, the controller can also be used for controlling the oscillation timing of pulsed laser light.

According to a fourth aspect, in the scanning reduced projection optical system according to any one of the first to third aspects, the zoom homogenizer includes an array mask provided immediately before the first lens array or between the first lens array and the second lens array, the array mask having an opening group in which openings are arrayed so that each of the openings faces each of lens elements of the lens array, the openings each having a size smaller than a size of each lens element. With this configuration, a virtual image due to stray light between the lens elements can be eliminated, and an extremely minute image having a stable and uniform energy distribution can be formed on the donor substrate onto which the opening shape on the photomask is reduced and projected. Further, a minute image having a desired shape can be formed according to the opening shape or arrangement of the photomask, irrespective of the lens element shape.

When the lens elements are of a cylindrical type, an array mask having elongated openings may be used in combination with the lens elements. The position of the array mask is a matter of design choice determined while checking the irradiation area on the photomask by using a beam profiler or the like, as long as the array mask is located immediately before or immediately after the first lens array or between the first lens array and the second lens array. The number of lens elements does not necessarily agree with the number of opening groups in the array mask. For example, NA of the optical system can be adjusted by reducing the number of openings in an outer peripheral portion of the array mask.

As an example of the predetermined size, letting the element size of the fly eye-type first lens array or the size of openings in the array mask provided immediately before the first lens array be dA, the focal length of the first lens array be f1, the focal length of the second lens array be f2, and the distance between the first and second lens arrays be a (here, a=f2), and letting the focal length of the condenser lens be fC, the focal length of the field lens in the projection lens system be fF, and the distance between these lenses be b, the predetermined size (DP) of the irradiation area imaged onto the photomask is represented by the following equation.

$$DP = \frac{dA * fC * fF * (f1 + f2 - a)}{f1 * f2 * (fC + fF - b)}$$

This configuration, however, may be unfavorable because diffraction occurs due to the effect of aberration of the first lens array or the array mask. This drawback is avoided by moving the first lens array toward the light source, and placing the array mask in the vicinity of the light source-side focus position of the second lens array. In addition, the use efficiency of pulsed laser light cut out by the array mask can be increased.

According to a fifth aspect, in the scanning reduced projection optical system according to the fourth aspect, the array mask has different kinds of opening groups arrayed in plane of a base material of the array mask, and the opening groups are different from each other in size or shape or in number of openings and capable of being used in a switchable manner.

When the number of openings in the array mask is smaller than the number of lens elements in the first lens array, the array mask has a function of variant illumination. FIG. 4 depicts an example of the array mask in which an opening group for variant illumination and an opening group opposed thereto as many as the lens elements of the lens array are arrayed in one base material.

According to a sixth aspect, in the scanning reduced projection optical system according to the fourth or fifth aspect, the array mask is installed on a mount including a $\theta$ axis to enable minute adjustment of rotation around an optical axis.

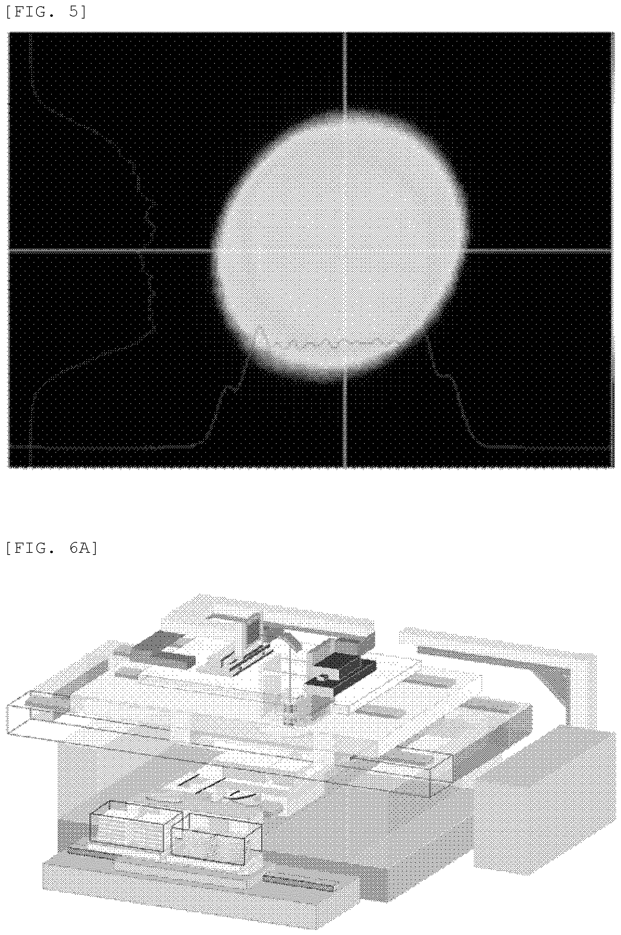

Emitted light from the lens elements of the second lens array is superimposed on the photomask by the condenser lens to form a uniform image. Here, in the relative positional relation between the array mask and the second lens array, misalignment in a plane perpendicular to the optical axis does not affect the uniformity. However, a deviation in the rotational direction ($\theta$) around the optical axis blurs the contour of the formed image, causing multiple image formation. This state is depicted in FIG. 5. (Here, an array mask having a circular opening shape is used.) The effect of such a deviation in the rotational direction increases as the formed image becomes smaller.

According to a seventh aspect, in the scanning reduced projection optical system according to any one of the first to sixth aspects, the optical devices are compatible with an oscillation wavelength by excimer laser.

An eighth aspect provides a laser processing apparatus that uses emitting multimode pulsed laser light toward irradiation targets on a substrate to induce a reaction, wherein the scanning reduced projection optical system according to any one of the first to sixth aspects reduces and projects the multimode pulsed laser light oscillating from a laser apparatus onto a substrate held on a stage having drive axes of at least an X axis and a Y axis.

Here, the irradiation targets on the substrate include defective micro devices and unnecessary portions of the functional film on a circuit board as described above. The induced "reaction" as used herein includes, but not limited to, mechanical reaction, optical reaction, electrical reaction, magnetic reaction, and thermal reaction.

A ninth aspect provides a LIFT apparatus for mounting or retransfer, or both, wherein the LIFT apparatus includes the laser processing apparatus according to the eighth aspect, the substrate is a donor substrate having a surface on which the irradiation targets are located, the LIFT apparatus emits the pulsed laser light from a back surface of the donor substrate toward the irradiation targets to selectively strip or separate the irradiation targets and subject the irradiation targets to LIFT onto a receptor substrate opposed to the donor substrate.

The stage is a donor stage configured to hold the donor substrate in an orientation in which the back surface faces an incident side of the pulsed laser light. The LIFT apparatus further includes a receptor stage configured to hold the receptor substrate and having an X axis, a Y axis, a vertical Z axis, and a $\theta$ axis rotated in an XY plane. The scanning reduced projection optical system and the donor stage are installed on a first surface plate. The receptor stage is installed on a second surface plate or a base surface plate. The first surface plate and the second surface plate are each independently installed on the base surface plate.

As used herein "selectively strip or separate the irradiation targets" means that when the irradiation targets are micro devices, the micro devices themselves are selectively stripped from the donor substrate, and when the irradiation targets each are a functional film or the like printed or applied in the form of a sheet on the donor substrate, the functional film or the like is selectively stripped or separated at a portion corresponding to the imaging position and size of laser light reduced and projected through the opening on the photomask. It should be noted that this separation or stripping includes a case where an ablation process is not involved.

It should be noted that since both stages perform step-and-repeat operation, that is, both stages remain at rest during laser light emission, a rolling guide type, which provides physical contact with a guide and is stable, is more preferable than an air bearing type even in consideration of costs.

On the other hand, all of the surface plates on which these stages are installed, including the first surface plate, the second surface plate, and the base surface plate, need to be made of a rigid material such as iron and steel, stone, or ceramics. Preferably, stone such as granite is used as the stone.

With the configuration described above, the position accuracy and the position stability of irradiation targets subjected to LIFT onto the receptor substrate are determined by the relative positional relation among the mask, the reduced projection lens, and the donor substrate with less variations by virtue of the installation structure of the scanning reduced projection optical system and by virtue of the stage for each substrate free from vibrations, and by the position accuracy of array of the irradiation targets on the donor substrate.

According to a tenth aspect, in the LIFT apparatus according to the ninth aspect, a controller for the scanning mirror includes a function of controlling the scanning mirror for scanning an optical axis of pulsed laser toward an opening on the photomask and controlling irradiation of the pulsed laser light, the opening being selected based on position information of the irradiation targets on the donor substrate and information on LIFT target positions onto the receptor substrate, the position information and the information on LIFT target positions being acquired in advance.

In particular, for example, when the LIFT apparatus is used as a retransfer apparatus, the possibility cannot be denied that there are no-device sections or defective sections in which defective devices are mounted on the donor substrate for retransfer. Then, in order that laser light from the scanning reduced projection optical system is emitted only toward the irradiation targets on the donor substrate to be subjected to LIFT that are selected based on information on the respective defective sections of the receptor substrate as a LIFT destination and the donor substrate as a LIFT source, the scanning mirror is controlled such that the optical axis is scanned toward the openings on the photomask facing the selected irradiation targets.

According to an eleventh aspect, in the LIFT apparatus according to the ninth or tenth aspect, the donor stage can hold two or more donor substrates and uses the two or more donor substrates in a switchable manner.

For example, pulse laser light having a predetermined size that is reduced and projected by the scanning reduced projection optical system according to the present invention is emitted to a first donor substrate on which a conductive paste film is applied to perform LIFT (paste printing) of the conductive paste film onto the position of the opposed receptor substrate, at a portion corresponding to the size of the position. Subsequently, the donor stage is moved to switch the first donor substrate to a second donor substrate (carrier substrate), and micro devices on the carrier substrate are subjected to LIFT to the same position on the receptor substrate and fixed with the conductive paste film interposed.

According to a twelfth aspect, in the LIFT apparatus according to the ninth to eleventh aspects, the donor stage is suspended on a lower surface of the first surface plate.

The procedure of installing the axes of the donor stage is a matter of design choice, but preferably the donor stage is suspended from the lower surface of the first surface plate installed horizontally in the order of the X axis and the Y axis and under the θ axis, if present. The axial configuration of the receptor stage is also a matter of design choice.

According to a thirteenth aspect, in the laser processing apparatus according to the eighth aspect or the LIFT apparatus according to the ninth to twelfth aspects, the laser apparatus is an excimer laser apparatus.

A fourteenth aspect provides a LIFT method for mounting or retransferring irradiation targets on a donor substrate onto an opposed receptor substrate by using the LIFT apparatus equipped with the scanning reduced projection optical system according to any one of the ninth to thirteenth aspects. The method includes: an inspection step of previously acquiring "position information D" which is position information of the irradiation targets on the donor substrate and "position information R" which is LIFT target positions for the irradiation targets onto the receptor substrate; a division step of partitioning a region on the donor substrate into "division areas D" each having a predetermined size; a selection step of selecting a position of an irradiation target to be subjected to LIFT in a division area D, based on the position information D and the position information R; a transfer step of performing LIFT of the selected irradiation target in the division area D toward a division area R, which is defined as an area of the opposed receptor substrate for the sake of convenience, by using laser light emitted to the donor substrate through an opening of the photomask facing the position of the selected irradiation target (through the reduced projection lens); and a moving step of moving the donor substrate and the receptor substrate to the next LIFT region after the transfer step, wherein subsequently the transfer step and the moving step are repeated to mount or retransfer the selected irradiation target on the donor substrate onto the receptor substrate for the entire LIFT target region of the receptor substrate.

In the inspection step, there are a variety of methods for acquiring the position information of the mounted irradiation targets. For example, all or two or more sampled images of individual irradiation targets are processed to obtain individual barycenter coordinates. The method of acquiring the position information is a matter of design choice. The determination of origins of these coordinates is also a matter of design choice. The position information D and/or the position information R may be obtained by performing inspection using an independent inspection apparatus different from the present LIFT apparatus and acquiring the result by a controller of the present LIFT apparatus via communication means, or may be calculated from design numerical values by the present LIFT apparatus based on the measurement result in positioning (alignment) between the donor substrate and the receptor substrate. This inspection step is preferably performed before the division step, although depending on the total takt time of mounting or retransfer.

The position of the selected irradiation target in a division area D refers to, when the present LIFT method is used for mounting, the positions of all of the irradiation targets (excluding a defective section) on the donor substrate that face the LIFT target positions in the opposed division area R, and when used for retransfer, the position of an irradiation target (excluding a defective section (no-device section)) on the donor substrate facing a defective section (no-device section) on the receptor substrate.

The transfer step includes a case where pulsed laser light is oscillated in synchronization with the time when the optical axis is scanned toward the position of the selected irradiation target, without stopping scanning of the scanning mirror, and a case where scan and stop are repeated.

Further, the position information D can include not only the position coordinates of micro devices as irradiation targets normally mounted on the donor substrate or irradiation targets that can be stripped or separated normally but also the position coordinates of irradiation targets identified as being defective or missing (as abnormal position information). This is applicable to the position information R in the case where the present LIFT method is used for retransfer.

The maximum size of the division area D depends on the reduced projection lens included in the scanning reduced projection optical system installed in the present LIFT apparatus. In particular, the telecentric reduced projection lens has limitations in numerical aperture and magnification in view of its production cost, so the region on the photomask and thus on the donor substrate capable of LIFT per scan is limited depending on these specifications.

In the present LIFT method, irrespective whether the present LIFT apparatus is used for mounting or for retransfer, the division area D is set in a region of the donor substrate, the donor substrate and the receptor substrate are moved by step-and-repeat operation of the stages holding them, and LIFT is performed accurately while avoiding vibrations when these stages are stopped.

According to a fifteenth aspect, in the LIFT method according to the fourteenth aspect, the design mounting pitch of the irradiation targets on the donor substrate is 1/n times, where n is an integer equal to or greater than one, for example, one time, 1/2 times, or 1/3 times, the design mounting pitch calculated from the position information R when the LIFT method is used for mounting, or the design mounting pitch for the irradiation targets already mounted on the receptor substrate when used for retransfer.

It should be noted that when the LIFT target positions on the receptor substrate are arrayed in a matrix of $X \times Y$, the mounting pitch on the opposed donor substrate having the same size may be 1/n times in X row and 1/m times in Y row (n and m are integers different from each other and equal to or greater than one).

In a sixteenth aspect, first of all, it is assumed that there is an error in substrates between the actual mounting pitch of the irradiation targets on the donor substrate calculated from the position information D acquired at the inspection step and the mounting pitch on the receptor substrate calculated from the position information R similarly (in consideration of the difference from the mounting density on the donor substrate). The mounting pitch on the receptor substrate is calculated from the LIFT target positions of the irradiation targets (design positions) when the present LIFT method is used for mounting, and is the actual mounting pitch of the irradiation targets already mounted when used for retransfer.

In light of the manufacturing process of donor substrates, even when there are no defective devices or no-device sections on the donor substrate, the actual mounting pitch of the mounted irradiation targets may have an error ($\delta$Pi) from the design mounting pitch. Although this error does not have a tendency to vary with locations on the same substrate, there may be differences (having errors) among production lots of donor substrates and thus among donor substrates. In this case, the error $\delta$Pi is to be accumulated in accordance with the number of irradiation targets contained in the division area D.

According to a sixteen aspect, in the LIFT method according to the fifteenth aspect, a movement amount of each substrate in the moving step is a movement amount that cancels this "accumulated error amount".

In the sixteenth aspect, when the irradiation targets within the division area D are to be subjected to LIFT using the donor substrate with an error ($\delta$Pi) having a certain magnitude or greater, the accumulated error amount may exceed an allowable range in terms of LIFT position accuracy, depending on the positions of the irradiation targets within the area (the number of irradiation targets from a reference position). Let alone the deviation between the LIFT target positions on the receptor substrate and the positions of the irradiation targets on the donor substrate to be subjected to LIFT, the deviation between the target positions on which laser light passing through the openings on the photomask forms an image on the donor substrate and the positions of the irradiation targets to receive the irradiation poses a problem particularly when the mounting density of irradiation targets on the donor substrate is high and the pitch is narrow.

Then, in a seventeenth aspect, the allowable range of accumulated error amount is set, assuming that the spacing between irradiation targets adjacent to each other on the donor substrate is the upper limit, and in consideration of the difference between the irradiation size of laser light emitted toward the irradiation targets on the donor substrate and the size of the irradiation targets, and the influence of their misalignment on the LIFT position accuracy. When the allowable range is exceeded at a position where the accumulated error amount in the division area D is largest (for example, the lower right end when the upper left end is set as a reference), the size of the division area D in the division step in the sixteenth aspect is reduced to a size with which the accumulated error amount at that position falls within the allowable range, to obtain "corrected division area D".

The selected irradiation target within the corrected division area D is mounted or retransferred to within the "corrected division area R" set to the same size for the sake of convenience on the opposed receptor substrate. Thereafter, the moving step is performed to move the donor substrate and the receptor substrate by using the stages for LIFT onto the next corrected division area R. In doing so, the movement amount of each stage is adjusted such that the accumulated error amount is canceled.

In setting the allowable range of accumulated error amount, it is preferable to set the allowable range (the size of the corrected division area D), assuming that even when the accumulated error amount that exceeds the maximum value does not occur in one division area D, the accumulated error amount may exceed the maximum value as a result of repeating the moving step in accordance with the design pitch on the donor substrate (or on the receptor substrate) over the entire receptor substrate, or by simulation in advance.

According to an eighteenth aspect, in the LIFT method according to the seventeenth aspect, by a simulation program having the position information D, the position information R, the size of the division area D, and the allowable range as parameters, a size of the corrected division area D, a combination of movement amounts of the stages, and order of the steps such that the time required for mounting or retransfer over the entire receptor substrate is shortest are determined, and causes execution of the steps.

ADVANTAGEOUS EFFECTS OF INVENTION

A scanning reduced projection optical system is implemented, which scans a minute and stable irradiation area having a uniform and invariable energy distribution toward the openings arrayed on the photomask at high speed and reduces and projects the irradiation area onto the irradiation targets with high uniformity and high accuracy while compensating for scanning accuracy deficiencies of the scanning mirror, without using $f\theta$ lenses or telecentric reduced projection lenses with large apertures. The scanning reduce production optical system, and a defective-removing apparatus and a LIFT apparatus for mounting or retransfer equipped with the scanning reduced projection optical system are implemented at low costs.

BRIEF DESCRIPTION OF DRAWINGS

FIG. 1 is a conceptual diagram illustrating a photomask in which openings are arrayed in a matrix;
FIG. 2 is a conceptual diagram illustrating a photomask in which openings are arrayed in a row;
FIG. 3 is a conceptual diagram illustrating arrangement of components of a scanning reduced projection optical system (with no array mask);
FIG. 4 is a conceptual diagram illustrating an array mask in which a plurality of opening groups are arrayed;
FIG. 5 is a beam profile image of an irradiation area on a photomask ($\theta$ axis deviation);
FIG. 6A is a (three-dimensional) schematic conceptual diagram of a LIFT apparatus equipped with a scanning reduced projection optical system;
FIG. 6B is a schematic conceptual diagram of a LIFT apparatus equipped with a scanning reduced projection optical system;
FIG. 7 is a conceptual diagram of a configuration of components of a zoom homogenizer;
FIG. 8A is a conceptual diagram of an array mask;
FIG. 8B is a photograph of an array mask;
FIG. 9 is a conceptual diagram of arrangement of optical devices from the zoom homogenizer to a donor substrate;
FIG. 10A is a beam profile image illustrating an imaging state on a photomask with a rectangular array mask inserted;
FIG. 10B is a beam profile image illustrating an imaging state on a photomask with a circular array mask inserted;
FIG. 11 is a conceptual diagram of a photomask used in Example 1;
FIG. 12 is a beam profile image of laser light reduced and projected onto a donor substrate;
FIG. 13 is a conceptual diagram of an area in which micro devices are mounted over the entire effective area of a donor substrate;
FIG. 14 is a conceptual diagram in which a region on a six-inch donor substrate is partitioned into twenty-seven division areas;
FIG. 15 is a conceptual diagram depicting the relation between a position on the donor substrate and an accumulated error amount;
FIG. 16 is a conceptual diagram depicting an overlapping state of defective position information D and defective position information R;
FIG. 17 is a conceptual diagram in which the division areas of the substrates facing each other are opposed to each other and subjected to LIFT;
FIG. 18 is a conceptual diagram in which the division areas of the substrates not facing each other are opposed to each other and subjected to LIFT.

DESCRIPTION OF EMBODIMENTS

Herein after, embodiments for carrying out the present invention will be described below with specific examples and drawings. In the following description, the previously mentioned conceptual diagrams and the like may be used for the sake of convenience.

Example 1

The present Example 1 provides an example of a LIFT apparatus that mounts irradiation targets, which are micro devices (micro LED devices) each having a size of 30×60[μm] (X axis × Y axis) arrayed in a matrix with no defectives on a donor substrate having a size of six inches, onto a receptor substrate having the same size, into a matrix of 222×225, in total, 49,950 devices. The LIFT position accuracy required for about 50,000 micro devices mounted on the receptor substrate is ±2[μm], and the pitch in each axis direction is 450[μM]. On the donor substrate, micro devices are arrayed with no defectives (with no no-device sections) with a pitch 1/2 times the mounting pitch of the LIFT target positions on the receptor substrate, and the total number of micro devices is about 200,000. The distance (spacing) between the micro devices adjacent to each other is X:195[um] and Y:165[pm]. In the present example, for simplicity, the receptor substrate size is the same as the donor substrate size and the array pitches of micro devices on the X axis and the Y axis are the same, but these sizes and pitches are a matter of design choice.

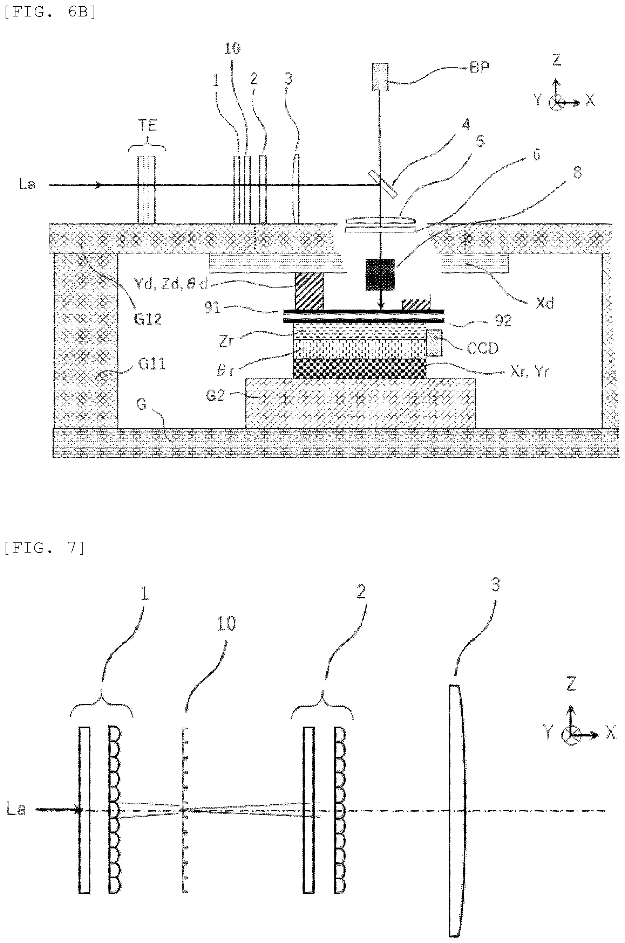

First of all, an example of the external appearance of the LIFT apparatus for implementing the present invention is depicted in FIG. 6A. The configuration in this external view is compatible with a receptor substrate having a size of 55 inches or more. FIG. 6B is a conceptual diagram of arrangement of main constituent parts. In FIG. 6B, a laser apparatus, various controllers, and a mount for each optical device, and the like are not illustrated, and the X axis, Y axis, and Z axis directions are depicted in the drawings. All of first surface plates (G11, G12) and a second surface plate (G2) were stone surface plates made of granite. Iron with high rigidity was used for a base surface plate (G).

It is preferable that a rotation adjustment mechanism for minutely adjusting the installation angle (orthogonal/parallel) is provided between the surface plates or between each surface plate and each stage. Specifically, the rotation adjustment mechanism described in the above Patent Document 1 is preferred. Further, it is preferable that a high-magnification camera for monitoring the position of each substrate is installed at a section different from a vibration system such as a stage holding the substrate.

A laser apparatus used in the present Example 1 is an excimer laser with an oscillation wavelength of 248[nm]. The spatial distribution of emitted laser light is approximately 8×24[mm] and the beam divergence angle is 1×3 [mrad]. They are expressed in (vertical×horizontal), and the numerical values are FWHM. Excimer lasers have various specifications, for example, vary in output, repetition frequency, beam size, and beam divergence angle, and some excimer lasers emit longitudinal laser light (the above vertical×horizontal is reversed). There are many excimer lasers that can be used in the present example by adding or eliminating an optical system or altering a design. Although depending on the size, the laser apparatus may be installed on a surface plate different from the base on which a stage group of a LIFT apparatus is typically installed.

The emitted light from the excimer laser enters a telescopic optical system and propagates to a zoom homogenizer ahead. Here, as depicted in FIG. 6B, the zoom homogenizer is provided on the first surface plate (G11) such that its optical axis is along the X axis. Laser light immediately before entering the zoom homogenizer is adjusted to approximately parallel light by the telescopic optical system, and enters the zoom homogenizer with approximately the same size along the X axis, irrespective of the position of the zoom homogenizer. In the present example, the size is approximately 25×25[mm] (Z×Y).

As depicted in the conceptual diagram in FIG. 7, each of lens arrays (1, 2) that constitute the zoom homogenizer in the present example is a set of two uniaxial cylindrical lens arrays combined at right angle in the YZ plane perpendicular to the optical axis. Laser light enters a first lens array (1) on the former stage, passes through an array mask (10) in the vicinity of the light source-side focus position of a second lens array (2) on the latter stage while condensing, and propagates through the second lens array (2) and a condenser lens (3) in this order.

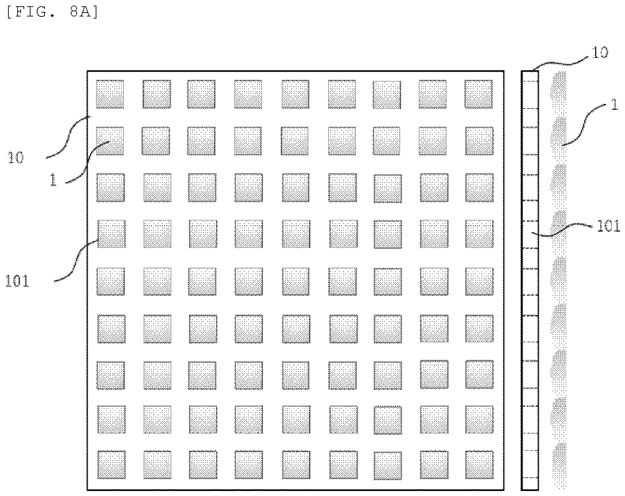

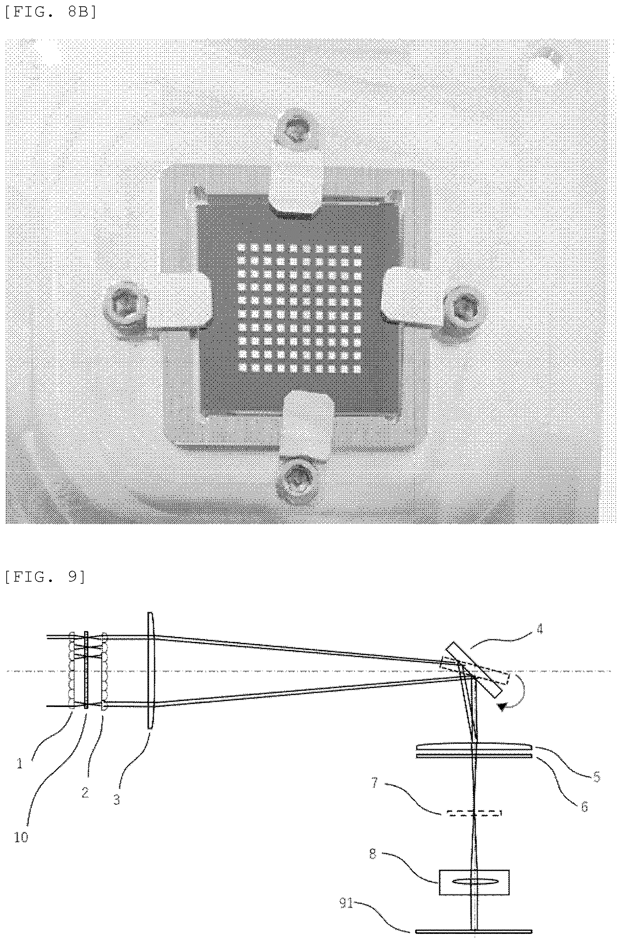

In the present Example 1, an array mask in which 0.75[mm]-square openings are arrayed in a matrix was used. FIG. 8A is its conceptual diagram. In this conceptual diagram, in order to depict a state of facing the lens array, the positional relation with the array mask (10) provided immediately before the fly eye-type lens array (1) and its openings (101) is conceptually illustrated. The array mask used in the present example is depicted in FIG. 8B.

FIG. 9 is a conceptual diagram of arrangement of optical devices from the zoom homogenizer to a donor substrate. The detailed arrangement position is a matter of design choice. Laser light emitted from the zoom homogenizer is scanned by a two-axis scanning mirror (4) and its controller, propagates to a field lens (5), and forms an image on a photomask (6).

The imaging plane on the photomask (6) is an image plane of an infinity-corrected optical system that includes the second lens array (2) and the condenser lens (3), in which the opening (101) of the array mask (10) is an object plane.

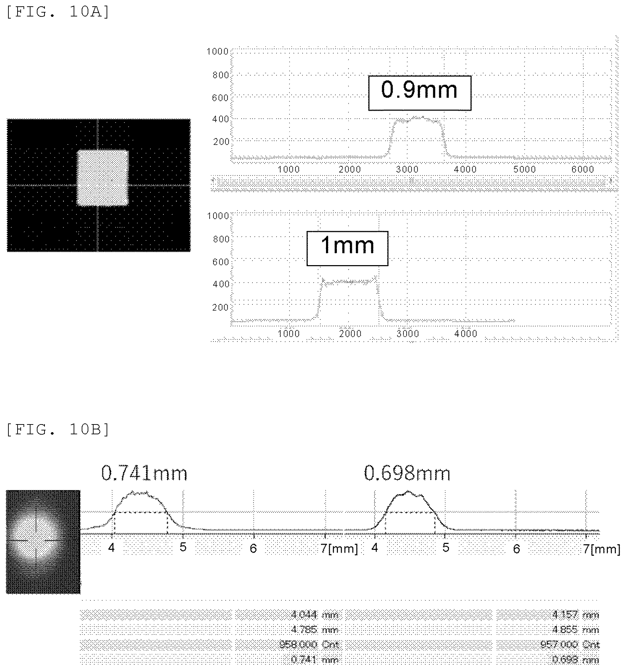

Laser light is scanned by the scanning mirror (4) and propagated toward one selected opening (61) on the photomask (6) and forms an image in an irradiation area having a predetermined size. FIG. 10A is its beam profile image. This predetermined size is the boundary (outer periphery, outer edge) of an energy distribution equal to or greater than a threshold that would induce a reaction if an unintended irradiation target was irradiated through the adjacent opening on the photomask not selected. The predetermined size is approximately 1[mm](FWHM) in the present example. FIG. 10B depicts a beam profile on the same photomask (6) when the array mask (10) having a circular opening shape is used.

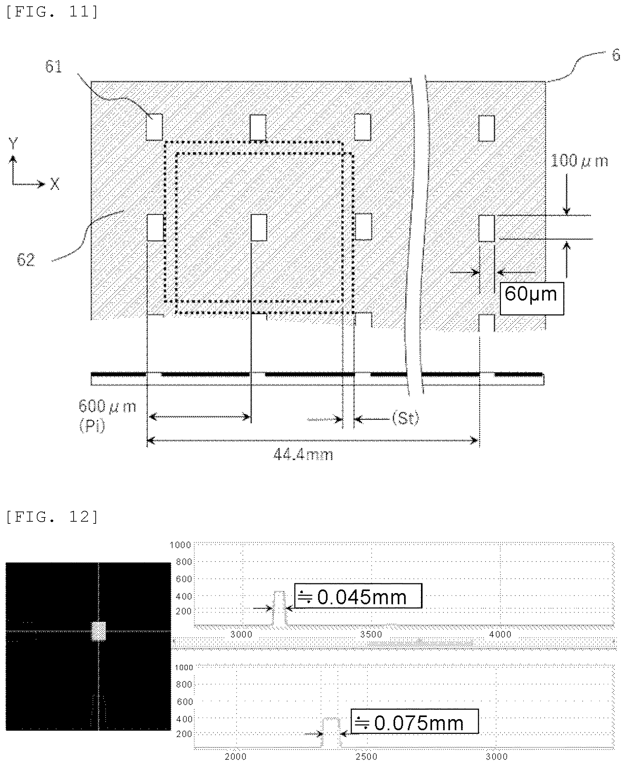

The photomask (6) used in the present Example 1 is a synthetic quartz plate on which a pattern is drawn (applied) by chrome plating. FIG. 11 is its conceptual diagram. Laser light passes through a window portion (61) depicted in white that is not chrome-plated and is interrupted by a colored portion (62) that is chrome-plated. The size of the opening is $60 \times 100[\mu m]$. Seventy four openings in the X axis direction with a pitch spacing of 600[pm], 25 openings in the Y axis direction with the same pitch, and a total of 1,850 openings are provided. The chrome-plated surface is the laser light emission side, while an anti-reflection coating for 248[nm] is provided on the incident side. Aluminum vapor deposition or a dielectric multilayer film may be used instead of chrome-plating.

The photomask (6) and the array mask (10) are fixed to respective dedicated mounts (not illustrated). The mounts each have an adjustment mechanism with in total six axes, namely, W axis, U axis, and V axis which move in the X axis, Y axis, and Z axis directions, respectively, R axis ($\theta$ axis) which is a rotation axis (around the optical axis) in the YZ plane, TV axis for adjusting inclination relative to the V axis, and TU axis for adjusting inclination relative to the U axis.

Laser light (optical axis thereof) passing through the zoom homogenizer is scanned at high speed by the scanning mirror (4) over the openings on the photomask, and the excimer laser apparatus produces pulse oscillation in synchronization with the timing at which the optical axis is scanned on the position of each opening.

Laser light passing through the photomask pattern propagates through the diaphragm (7) to an image-side telecentric projection lens (8) having a magnification of 3/4X, and is then reduced and projected toward a donor substrate (91) from its back surface to the position mounted with a micro device having a surface (underside) size of $30 \times 60[um]$ ($X \times Y$). FIG. 12 is a beam profile image of the projected laser light. The micro devices on the donor substrate receiving irradiation of the scanned laser light are subjected to LIFT one after another with a pitch of 450[um] into a matrix, and mounted on the opposed receptor substrate.

The number of $30 \times 60[\mu m]$ irradiation targets subjected to LIFT is the number corresponding to the number of $74 \times 25$ openings on the photomask, and the LIFT range is about $33 \times 11[mm]$.

The reduced projection lens (8) is telecentric on the image side and can be adjusted by a Z-axis driving stage holding this lens. In addition, an adjustment function in the Z axis direction of the donor substrate (Z-axis stage (Zd)) may be added to support imaging onto a light absorbing layer. However, it is necessary to consider deterioration in LIFT position accuracy due to increase in weight load on the donor stage.

To adjust the imaging position at the interface between the donor substrate surface and the light absorbing layer or the like, a real-time monitor is effective which uses a confocal beam profiler (BP) having a plane conjugate to the mask surface and the reduced projection lens as an image pickup surface. In the present Example 1, the spatial intensity distribution of laser light reduced and projected onto the interface between the donor substrate surface and the micro device is monitored in real time and with high resolution.

Laser light is scanned toward all of the openings on the photomask (6), and laser light is successively emitted toward the micro devices arrayed on the donor substrate and having the imaging position adjusted. Thus, 1,850 micro devices corresponding to the number of openings on the photomask are mounted onto the same number of LIFT target positions on the receptor substrate. A LIFT region including 1,850 positions corresponds to one area when the receptor substrate is divided into three in the X axis direction (A to C) and divided into nine in the Y axis direction (1 to 9), resulting in a total of 27 areas (A1 to A9, B1 to B9, C1 to C9). The size is about $33 \times 11[mm]$ which is determined by the scanning angle of the scanning mirror and the aperture diameter of the reduced projection lens. After LIFT on one area is completed, the donor substrate and the receptor substrate are moved to the next LIFT area. For example, the movement is 33.3[mm] in the X axis direction and 11.25[mm] in the Y axis direction. Thereafter, LIFT is performed at 1,850 positions again, and subsequently this is repeated for the whole of LIFT target positions to complete mounting of 49,950 micro devices from the donor substrate to the receptor substrate. The micro devices are mounted on the donor substrate with no defectives at a high density 1/2 times the pitch of LIFT target positions on the receptor substrate as described above, so mounting on four receptor substrates can be performed by using one donor substrate.

The time taken for mounting can be reduced to about 1/4, for example, when the predetermined size (DP) of the irradiation area of laser light onto the photomask can be made to the size with which four openings can be collectively irradiated as indicated by a dashed-dotted line in FIG. 1, depending on the relation between the imaging size of each opening of laser light onto the donor substrate and the energy density.

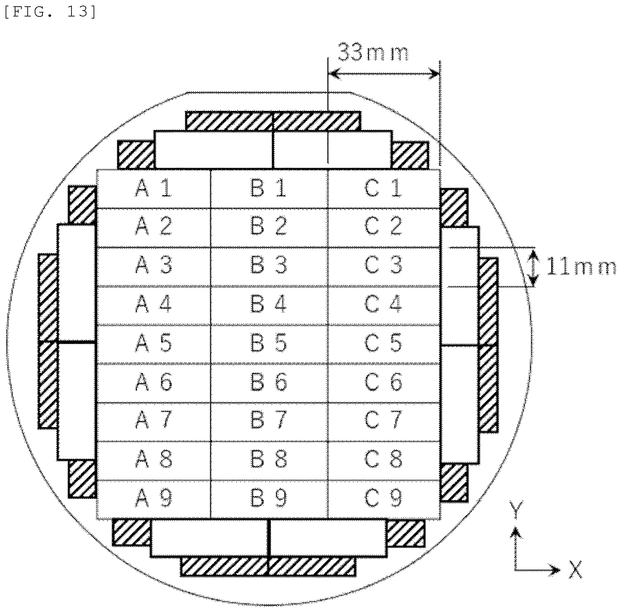

As depicted in FIG. 13, for example, when the donor substrate has a wafer shape and micro devices are mounted over its entire effective area, LIFT areas along the mounting areas for micro devices (hatched areas in the drawing) are set, and scanning is performed such that the scanning range of the scanning mirror is matched with the set areas, whereby LIFT of micro devices located at corners can be performed.

The foregoing is a specific example of the LIFT apparatus that mounts micro devices on the donor substrate onto the opposed receptor substrate, and the mounting method.

Example 2

In the present Example 2, a LIFT apparatus for correction according to the present invention is used to demonstrate an example of correction by retransfer onto defective sections corresponding to about 1% of a six-inch receptor substrate to be corrected (hereinafter simply referred to as "receptor substrate" in the present Example 2) on which $495 \times 495 = 245{,}025$ micro devices of 40[pm] square are mounted in a matrix with a pitch of 200[pm] between adjacent devices in the case where there are no transfer defectives. It is assumed that about 1% of no-device sections (and defective sections) are also distributed in micro devices for use in retransfer (correction) that are arrayed on a six-inch donor substrate for correction (hereinafter simply referred to as "donor substrate" in the present example), similarly to the receptor substrate. On the donor substrate in the present Example 2, micro devices are arrayed with a design pitch of 50[um] which is 1/4 times the design mounting pitch of micro devices mounted on the receptor substrate, and the total number of micro devices is 3.9 million or more. Thus, the spacing between adjacent micro devices is 10[pm]. The overall configuration of the scanning reduced projection optical system installed on the LIFT apparatus in the present Example 2 and the apparatus structure are similar to those of Example 1. The specifications and arrangement position of each optical device and a beam profile shape determined by these are a matter of design choice.

On the photomask (6) in the present Example 2, as depicted in FIG. 1, openings (Ma) of 200[pm] square, which is slightly larger than the shape determined by the magnification (1/4X) of the reduced projection lens (8) and the micro device size (40[um] square), are arrayed in a matrix of $165 \times 55$ with a 800[pm] pitch (Pi). This array corresponds to the array of micro devices mounted on the receptor substrate. The size of the irradiation area forming an image onto this photomask by the scanning reduced projection optical system is about 1[mm] square, similarly to the present Example 1, and is a size with which the openings adjacent to each other on the photomask can be irradiated without interfering with each other. Laser light passing through this opening forms an image toward a micro device for use in retransfer (correction) on the donor substrate (9) through the image-side telecentric reduced projection lens (8).

Excimer laser light having the above irradiation area size that is pulse-oscillated in synchronization with the operation of the scanning mirror (4) irradiates the 200[pm]-square opening on the photomask (6). The laser light passing through this opening passes through the image-side telecentric projection lens (8) with a magnification of 1/4X and is emitted from the back surface of the donor substrate toward the micro devices arrayed thereon without interfering with the adjacent micro devices with a spacing of 10[pm]. In the present example, the emitted pulsed laser light forms an image in a 50[pm] square, which is slightly larger than the micro device size, on a surface (underside) of the donor substrate to induce a reaction, thereby performing LIFT of a micro device at the position toward a no-device section on the receptor substrate.

Herein after, a specific LIFT method for retransfer (correction) will be described step by step.

(1) Inspection Step

Design position information and actual mounting positions obtained from image processing are acquired as position information of micro devices mounted on the donor substrate and on the receptor substrate. Specific coordinates were those of the barycenter position obtained from the shape of micro devices, and the coordinate origin was determined by referring to an orientation flat position of the substrate. Here, the position information on the donor substrate is referred to as "position information D", and the position information on the receptor substrate is referred to as "position information R".

The position information D includes those of a micro device determined as a defective that is not to be used for retransfer, and a no-device section in which a micro device is originally not mounted. Their position coordinates are calculated from the adjacent micro devices and acquired as "defective position information D". This is applicable to "defective position information R" in the position information R.

In the present example, the design pitch of micro devices arrayed on the donor substrate is 1/4 times the design pitch of micro devices mounted on the receptor substrate, and the actual pitch has an error between donor substrates and, in addition, between the donor substrate and the receptor substrate. This error is calculated from the position information D and R. In the present example, for simplicity, the position information R is a design pitch, and the value of an error pitch $\delta Pi$ of the donor substrate relative to the design pitch is +0.0075[$\mu$m].

(2) Division Step

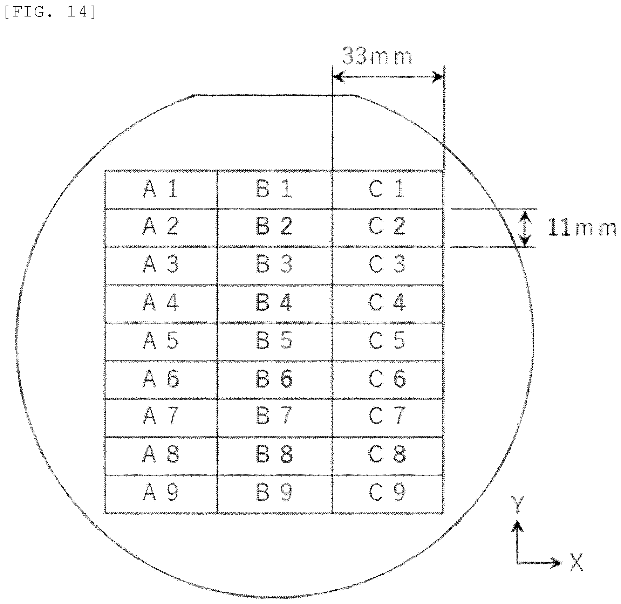

The region on the six-inch donor substrate is partitioned into 27 division areas ("division areas D"), similarly to Example 1. As depicted in FIG. 14, each area is $33 \times 11$[mm], and the division areas are depicted as A1 to A9, B1 to B9, and C1 to C9 for the sake of convenience in the drawing. The receptor substrate is also partitioned into 27 "division areas R" similarly, and LIFT is performed between the division areas opposed to each other.

The size of the division area D is a matter of design choice determined by the size of the photomask limited by the effective aperture diameter of the reduced projection lens and other specifications, and the reduced projection magnification, similarly to Example 1.

Here, the allowable range of the accumulated error amount obtained by multiplying the number of irradiation targets, 660(-1), in the longitudinal axis (X axis) direction contained in the division area D by the above error δPi was set to ±5[μm].

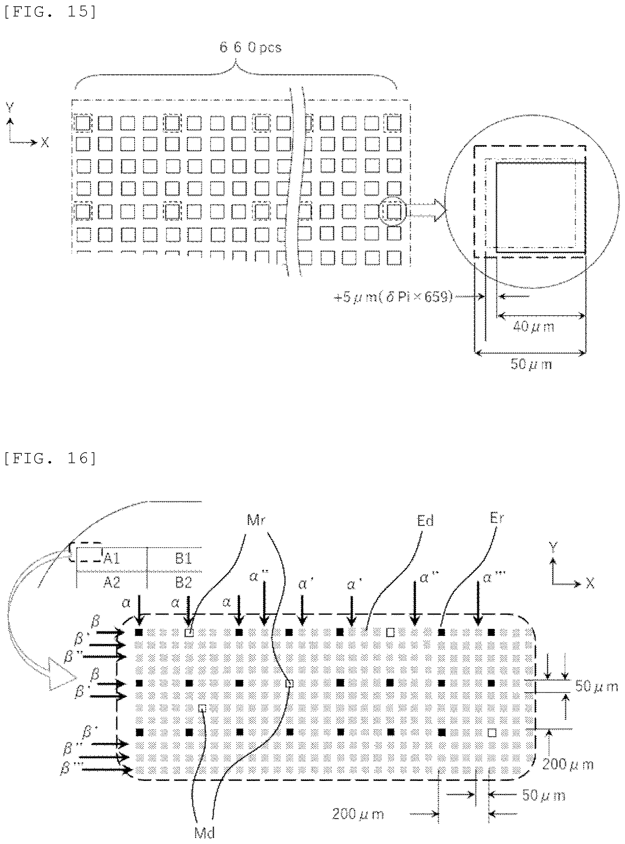

As depicted in FIG. 15, when the upper left end of the division area D (dashed-dotted line) serves as a reference of alignment, the allowable range is set as desired, based on the limit in which a 50[pm] square (broken line in the drawing), which is a size with which laser light passing through the opening (61) on the photomask (6) forms an image onto a 40[pm]-square micro device on the donor substrate, can irradiate the entire surface of a micro device (solid line) at the right end where the accumulated error amount is largest. The 40[μm] square indicated by a dash-dot-dot line in the drawing is the mounting position of the micro device on the donor substrate in design and is located to the center relative to the imaging size indicated by a broken line. In the present example, in any of the micro devices mounted within the division area D, the accumulated error amount from the design position is within the allowable range (659×0.0075≈4.94). In this division step, therefore, it is not necessary to set the reduced "corrected division area D".

(3) Selection Step

For the division area R of the same size opposed to the division area D, among the micro devices arrayed in the division area D, the micro devices opposed to no-device sections (defective position information R of about 91 positions) equivalent to about 1% of 9,075 micro devices mounted in the division area R are subjected to LIFT one by one toward the no-device sections.

However, 1,452 defective devices equivalent to about 1% of the mounted micro devices (660×220=145,200) exist even in the division area D, and these (defective position information D) may overlap with the defective position information R. FIG. 16 depicts this state. This state is an image where the receptor substrate is observed through the donor substrate. A partial area of the array of micro devices on the donor substrate is depicted. In this drawing, the vicinity of the upper left surrounded by a broken line in division area A1 is depicted in an enlarged view, which illustrates the array of micro devices on the donor substrate located in this area.

Here, the positions of no-device sections in which defective devices have been removed in advance from the receptor substrate in the removal step are indicated by white boxes (Mr), for the sake of convenience, the positions of micro devices mounted normally on the receptor substrate are indicated similarly by black boxes (Er), and the positions of micro devices arrayed on the donor substrate 16 times as densely as those on the receptor substrate are indicated by gray boxes (Ed). (Ed at the position overlapping with Er or Mr is not illustrated in the drawing.) As previously mentioned, the pitch of micro devices Ed on the donor substrate is 50[μm], and the pitch of micro devices Er on the receptor substrate is 200[pm].

First of all, correction of a first receptor substrate by a donor substrate to be used for correction for the first time will be described.

(3-1) The defective position information D is compared with the defective position information R in a unit of substrates to preliminary check the position where the no-device section (Mr) and the defective device position (Md) overlap each other. The overlapping to be checked here means the overlapping in a unit of substrates (all of 27 areas) at positions (in total 245,025 positions per substrate) where β row groups aligned in the X axis direction on the donor substrate depicted in the drawing intersect α row groups similarly aligned in the Y axis direction on the donor substrate. Other α', α", a''', β', β", and β''' row groups represent the array positions of other micro devices mounted 16 times densely on the donor substrate. (In the drawing, only three α row groups from the left are indicated by arrows, and only two β row groups from the top are indicated by arrows. Other "'" row groups are indicated similarly by arrows to a limited extend.)

If there is no overlapping, in the selection step, the position (Ed) of the micro device on the donor substrate facing the no-device section (Mr) is selected. The case where overlapping is found will be described later.

(3-2) On the other hand, in the case of correction by a combination of the donor substrate already used for correction and the (first or) second and subsequent receptor substrates, whether there is overlapping is preliminarily checked by comparing the no-device section-distributed position information (Mr) on the receptor substrate with all position information including the position information (Md) of about 1% defective devices originally on the donor substrate, plus the position information already used where micro devices have been used for retransfer in the past and are missing (1% Md + Md already used). As a result, if there is no overlapping, in the selection step, the position (Ed) of the micro device on the donor substrate facing the no-device section (Mr) is selected.

(4) Transfer Step

In the above (3-1) or (3-2), after the position of the micro device on the donor substrate to be used for retransfer is selected, retransfer is started from the above division area A1 for correction of the first or second and subsequent receptor substrates. By the scanning mirror (4), the optical axis of laser light is scanned along the β row on the donor substrate through the photomask (6) and the reduced projection lens (8). In this area, at the selected position, by virtue of excimer laser light oscillating at the timing of scanning the optical axis, the micro device mounted on the selected position on the donor substrate is subjected to LIFT toward the opposed no-device section (Mr) on the receptor substrate.

(5) Moving Step

After the correction to area A1 of the receptor substrate by the micro device at the selected position in area A1 of the donor substrate is finished, correction is performed similarly on the next area A2. In shifting the areas, correction is performed for all the areas in an arbitrary order (for example, A1 to A9 $_\rightarrow$ B1 to B9 $_\rightarrow$ C1 to C9) by moving the stage holding each substrate. The movement amount of the stage during shifting of the division areas is set such that the accumulated error amount (about +4.95[um]) is canceled. After completion of correction on all the division areas that require correction, this receptor substrate is replaced by the next receptor substrate to be corrected.

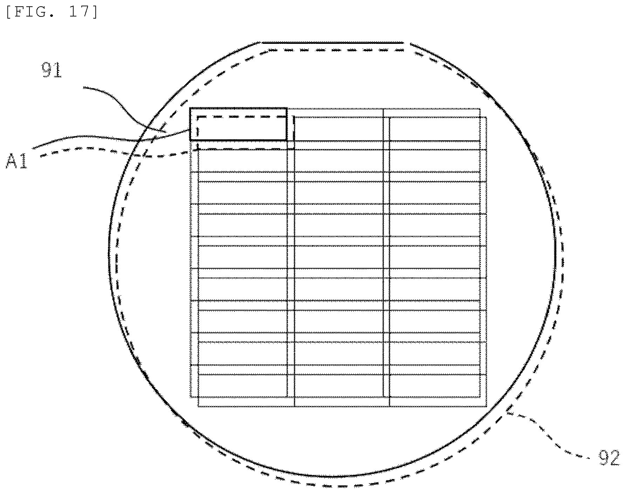

On the other hand, if overlapping is found in the comparison in a unit of substrates in the above (3-1) or (3-2), the row group to be compared is changed from α to α' row group, or from β to β' row group, and in the combination of row groups after change (at the intersection of the changed row groups), whether there is overlapping is checked by comparison in a unit of substrates, in the same manner as the above (3-1) or (3-2). In this case, there are 15 possible combinations of row groups. If a combination of row groups with no overlapping is found in a unit of substrates, the position (Ed) of the micro device on the donor substrate facing the no-device section (Mr) is selected based on the found combination. Before the transfer step, the substrates are moved in accordance with the combination of row groups. FIG. 17 depicts the position between the substrates in retransfer between the division areas (A1).

In the comparison in a unit of substrates in the above (3-1) or (3-2), if a combination of row groups with no overlapping is not found in any of 15 combinations, the comparison is performed in a unit of narrower division areas opposed to each other, rather than in a unit of larger substrates. For example, the comparison is limited to area A1 of the receptor substrate and area A1 of the donor substrate opposed thereto. As a result, if there is no overlapping at the intersection of α row group and β row group, the process directly proceeds to the transfer step. If there is overlapping, a combination of other row groups with no overlapping (for example, α' row group and β" row group) is searched for in at least division areas (A1) of the opposed substrates. There are 16 combinations at most. After the correction of division area A1 of the receptor substrate by division area A1 of the donor substrate is completed in the found combination of row groups with no overlapping, the next areas A2 are compared similarly and then area A2 of the receptor substrate is corrected in a combination of row groups with no overlapping. Subsequently, this is repeated for donor A3 and receptor A3, donor A4 and receptor A4, .... For example, if there is overlapping only between division areas B5 and except for these areas there is no other overlapping in a unit of substrates, the comparison limited to the preceding and subsequent areas is not necessary.

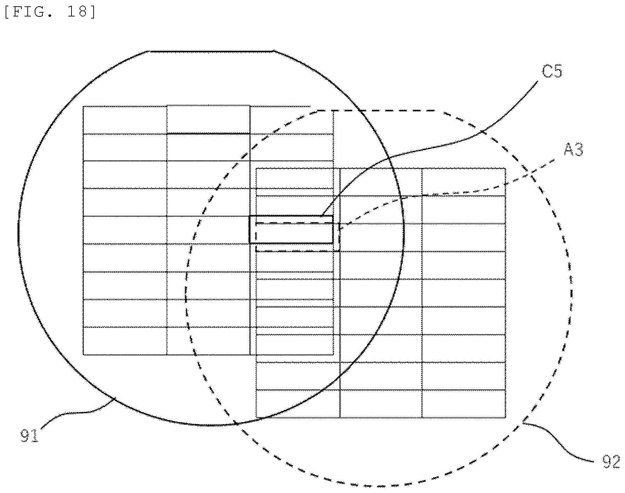

If a combination of row groups with no overlapping is not found in the comparison between the opposed areas described above (A1 and A1, B1 and B1, ...), at this point of time, the limited comparison between the area on the donor substrate to be compared and the division area opposed thereto is extended to the comparison with other 26 division areas of the donor substrate, and a combination of row groups with no overlapping is searched for in a unit of areas. FIG. 18 depicts this state. Here, in a combination of division area C5 of the donor substrate and division area A3 of the receptor substrate, for example, retransfer is at the intersection of a''' group and β''' group. However, it should be noted that a combination of row groups with no overlapping has to be searched for between the division areas, in consideration of defective position information (Md) that reflects the missing position of the micro device already used for correction before the moment when the division areas to be compared are changed. In addition, it is necessary to examine (calculate) whether an acceptable takt time can be achieved, considering all the factors involved such as the time required for frequent shifting of row groups and stage movement for shifting to the opposed division areas. The selection of ranges to be compared for overlapping and the timing of replacement for donor substrate are determined as appropriate in accordance with the calculation result.

Optionally, the transfer step may be performed irrespective of whether there is overlapping in defective position information, as long as direct emission of laser light onto the receptor substrate does not have an adverse effect, and, for example, a no-device section on which retransfer was not performed due to overlapping may be corrected by a different donor substrate in the second or later correction. Alternatively, the comparison for each substrate and the comparison for each division area may be performed in combination in a timely manner, based on a simulation of takt time. Further, a combination of the comparison method with the simulated shortest takt time and the range of comparison may be defined, based on the position information of each substrate acquired in advance in the inspection step.

In a case where retransfer is performed for each division area R as in the present example, that is, in a case where the scanning mirror having a scan speed of about 30 openings per second is scanned for retransfer at once for the number ($165 \times 55$) of openings on the photomask, supposing that there is no overlapping in defective position between the substrates, the time required for correction (at about 90 positions) per division area is about three seconds. The time required from the setting of substrates to completion of correction is approximately 90 seconds, considering the time taken for 27 division areas and the time taken for moving each substrate for shifting the division areas.

Correction of defective devices which reach 1% can be implemented at much higher speed, compared to the takt time of about 2450 seconds when using the above conventional apparatus that requires about 1 second for retransfer of a micro device at a single position. The significant advantage of takt time in the present example can be maintained even considering the calculation time required for comparison (checking for overlapping) and the stage moving time required for the row group shifting and division area shifting for avoiding overlapping.

In a case where the division areas are compared randomly without being limited to the opposed division areas, or in a case where the accumulated error amount is taken into consideration, it is preferable that by a simulation program having the position information D, the position information R, the size of the division area D, and the allowable range of the accumulated error amount each of which is acquired in the inspection step as parameters, the size of the corrected division area D, a combination of movement amounts of the stages, and order of the steps are determined such that the time required for mounting or retransfer over the entire receptor substrate is shortest, thereby optimizing the steps.

Up until now, some embodiments according to the present invention. According to other aspect, the present invention can be described as the following (1) to (19).

(1) A scanning reduced projection optical system for use in a laser processing apparatus that uses emitting laser light toward irradiation targets to induce a reaction,
wherein the scanning reduced projection optical system comprises an infinity-corrected optical system, a scanning mirror, and a photomask.

(2) A laser processing apparatus that uses emitting laser light toward irradiation targets to induce a reaction,
wherein the laser processing apparatus comprises a laser apparatus configured to oscillate the laser light, an infinity-corrected optical system, and a scanning mirror.

(3) A LIFT apparatus for emitting laser light toward a donor substrate having irradiation targets to move the irradiation targets from the donor substrate to a receptor substrate,
wherein the LIFT apparatus comprises a laser apparatus configured to oscillate the laser light, an infinity-corrected optical system, and a scanning mirror.

(4) A laser processing method in which laser light is emitted toward irradiation targets to induce a reaction,
wherein laser light is emitted toward the irradiation targets by using a scanning reduced projection optical system comprising an infinity-corrected optical system, a scanning mirror, and a photomask.

(5) A LIFT method in which laser light is emitted toward a donor substrate having irradiation targets to move the irradiation targets from the donor substrate to a receptor substrate,
wherein laser light is emitted toward the irradiation targets by using a scanning reduced projection optical system comprising an infinity-corrected optical system, a scanning mirror, and a photomask.

(6) A manufacturing method of an irradiation target-mounted substrate in which laser light is emitted toward a donor substrate having irradiation targets to move the irradiation targets from the donor substrate to a receptor substrate,
wherein laser light is emitted to the irradiation targets by using a scanning reduced projection optical system comprising an infinity-corrected optical system, a scanning mirror, and a photomask.

(7) The manufacturing method of an irradiation target-mounted substrate according to (6), wherein the irradiation targets are micro devices.

(8) The manufacturing method of irradiation target-mounted substrate according to (7), wherein the micro devices are micro LEDs.

(9) The manufacturing method of an irradiation target-mounted substrate according to (7) or (8), wherein the micro devices are arranged on the donor substrate in a matrix.

(10) The method of manufacturing an irradiation target-mounted substrate according to (6), wherein each of the irradiation targets is a film.

(11) The method of manufacturing an irradiation target-mounted substrate according to (10), wherein the film is an electrically conductive film or an adhesive film.

(12) The method of manufacturing an irradiation target-mounted substrate according to (10), wherein the film is an organic EL film.

(13) A method of manufacturing a micro device-mounted substrate, the method comprising steps of:

emitting laser light toward a first donor substrate having a film to move the film from the first donor substrate to a receptor substrate so as to obtain a film-mounted substrate; and

emitting laser light toward a second donor substrate having a micro device to move the micro device from the second donor substrate onto the film of the film-mounted substrate,
wherein laser light is emitted toward the film or the micro device by using a scanning reduced projection optical system comprising an infinity-corrected optical system, a scanning mirror, and a photomask.

(14) A defective section-removing method in which laser light is emitted toward a defective section in a donor substrate having the defective section to remove the defective section from the donor substrate,
wherein laser light is emitted toward the defective section by using a scanning reduced projection optical system comprising an infinity-corrected optical system, a scanning mirror, and a photomask.

(15) A retransfer method in which laser light is emitted toward a donor substrate having irradiation targets to move the irradiation targets from the donor substrate to a receptor substrate,

> wherein the receptor substrate has a region in which the irradiation targets have been mounted in advance, and a defective region in which no irradiation target is mounted in a mounting target region, and
> laser light is emitted toward an irradiation target on the donor substrate by using a scanning reduced projection optical system comprising an infinity-corrected optical system, a scanning mirror, and a photomask so that the irradiation target is moved to the defective region in the receptor substrate.

(16) A LIFT method in which laser light is emitted toward a donor substrate having irradiation targets to move the irradiation targets from the donor substrate to a receptor substrate,

> wherein the irradiation targets on the donor substrate have a defective region, and
> laser light is emitted toward the irradiation targets excluding the defective region by using a scanning reduced projection optical system comprising an infinity-corrected optical system, a scanning mirror, and a photomask, so that the irradiation targets are moved to the receptor substrate.

(17) A laser processing method in which laser light is emitted toward irradiation targets to induce a reaction,
wherein the laser light is scanned by a scanning mirror so that the laser light forms an image onto a photomask as an image plane of an infinity-corrected optical system, and the laser light passing through the photomask is reduced and projected onto the irradiation targets.

(18) A LIFT method in which laser light is emitted toward a donor substrate having irradiation targets to move the irradiation targets from the donor substrate to a receptor substrate,
wherein the laser light is scanned by a scanning mirror so that the laser light forms an image onto a photomask as an image plane of an infinity-corrected optical system, and the laser light passing through the photomask is reduced and projected onto the irradiation targets.

(19) A method of manufacturing an irradiation target-mounted substrate in which laser light is emitted toward a donor substrate having irradiation targets to move the irradiation targets from the donor substrate to a receptor substrate,
wherein the laser light is scanned by a scanning mirror so that the laser light forms an image onto a photomask as an image plane of an infinity-corrected optical system, and the laser light passing through the photomask is reduced and projected onto the irradiation targets.

(20) A scanning reduced projection optical system for use in a laser processing apparatus that uses emitting laser light toward irradiation targets to induce a reaction,
the scanning reduced projection optical system comprising a first lens array, a second lens array, a scanning mirror, and a photomask.

(21) The scanning reduced projection optical system according to (20), wherein the first lens array or the second lens array comprises an array of lens elements.

(22) The scanning reduced projection optical system according to (21), wherein the lens elements are of a fly eye type, a cylindrical type, or a spherical type.

(23) The scanning reduced projection optical system according to any one of claim (20) to (22), wherein the first lens array or the second lens array is a combination of uniaxial cylindrical lenses at right angle.

(24) The scanning reduced projection optical system according to any one of (20) to (23), wherein an array mask is arranged immediately before the first lens array.

(25) The scanning reduced projection optical system according to any one of (20) to (24), wherein an array mask is arranged between the first lens array and the second lens array.

(26) The scanning reduced projection optical system according to (24) or (25), wherein the array mask has an opening group.

(27) The scanning reduced projection optical system according to (26), wherein openings forming the opening group are circular, elliptical, square, or rectangular.

(28) The scanning reduced projection optical system according to (26) or (27), wherein openings forming the opening group each have a size smaller than a size of each lens element.

(29) The scanning reduced projection optical system according to any one of (24) to (28), wherein the array mask has at least two kinds of opening groups.

(30) The scanning reduced projection optical system according to (29), wherein the at least two kinds of opening groups are different from each other in size of openings forming each of the opening groups, shape of the openings, number of the openings, or arrangement of the openings.

(31) A scanning reduced projection optical system for use in a laser processing apparatus that uses emitting laser light toward irradiation targets to induce a reaction,

wherein the scanning reduced projection optical system is telecentric only on an image side.

(32) A defective section-removing method in which laser light is emitted toward a defective section in a donor substrate having the defective section to remove the defective section from the donor substrate,

wherein laser light is emitted toward the defective section using a scanning reduced projection optical system comprising a galvano scanner and a photomask.

(33) The defective section-removing method according to (32),

wherein the photomask has a circular, elliptical, square, or rectangular opening.

(34) The defective section-removing method according to (32) or (33), wherein the photomask has a region in which openings are arranged in a matrix.

(35) The defective section-removing method according to any one of (32) to (34), wherein the photomask has at least two kinds of opening groups.

(36) The defective section-removing method according to (35), wherein the at least two kinds of opening groups are different from each other in size of openings forming each of the opening groups, shape of the openings, number of the openings, or arrangement of the openings.

(37) A retransfer method in which laser light is emitted toward a donor substrate having irradiation targets to move the irradiation targets from the donor substrate to a receptor substrate,

wherein the receptor substrate has a region in which the irradiation targets have been mounted in advance, and a defective region in which no irradiation target is mounted in a mounting target region, and
laser light is emitted toward an irradiation target on the donor substrate by using a scanning reduced projection optical system comprising a galvano scanner and a photomask so that the irradiation target is moved to the defective region in the receptor substrate.

(38) A LIFT method in which laser light is emitted toward a donor substrate having irradiation targets to move the irradiation targets from the donor substrate to a receptor substrate,

wherein the irradiation targets on the donor substrate have a defective region, and
laser light is emitted toward the irradiation targets excluding the defective region by using a scanning reduced projection optical system comprising a galvano scanner and a photomask so that the irradiation targets are moved to the receptor substrate.

The constituent elements in various embodiments above can be subdivided, and each of the subdivided constituent elements can be used singly or in combination, and introduced to the above (1) to (38). For example, the manner of use and the arrangement of various lenses, the kind of laser light, various configurations and control methods in the laser processing apparatus, the kind and shape of the photomask, the shape and arrangement of openings, the kind and shape of the irradiation targets, the reaction mechanism of laser lift off, and the mechanism of optical systems are typical examples.

INDUSTRIAL APPLICABILITY

The present invention can be applied to a part of manufacturing processes of micro LED displays.


**Claims**

1.    A scanning reduced projection optical system for use in a laser processing apparatus that uses emitting multimode pulsed laser light toward irradiation targets on a substrate to induce a reaction,

wherein the scanning reduced projection optical system comprises a lens array-type zoom homogenizer, a scanning mirror, a photomask, and a projection lens system that is telecentric on at least an image side,
the photomask has a plurality of openings arrayed with a predetermined pitch, the openings each having a predetermined shape,
the zoom homogenizer comprises a first lens array and a second lens array, and a condenser lens, wherein the zoom homogenizer forms an image of an irradiation area onto the photomask and compensates for variations in position and size of the irradiation area and in energy intensity distribution in the irradiation area, the irradiation area having a predetermined size that covers an opening group having one or more openings adjacent to each other on the photomask,

the predetermined size is a size with which the irradiation area does not extend to any other openings adjacent to the opening group, and

the scanning mirror is scanned by a drive axis controller with one or more axes.

2. The scanning reduced projection optical system according to claim 1,

wherein the projection lens system comprises a field lens and a reduced projection lens, and
the field lens is located between the condenser lens and the photomask.

3. The scanning reduced projection optical system according to claim 1 or 2, wherein the scanning mirror comprises a two-axis galvano scanner.

4. The scanning reduced projection optical system according to any one of claims 1 to 3, wherein an array mask is provided immediately before the first lens array or between the first lens array and the second lens array, the array mask comprising an opening group in which openings are arrayed so that each of the openings faces each of lens elements of the first lens array, the openings each having a size smaller than a size of each lens element.

5. The scanning reduced projection optical system according to claim 4, wherein the array mask has different kinds of opening groups arrayed in plane of a base material of the array mask, and the opening groups are different from each other in size or shape or in number of openings and capable of being used in a switchable manner.

6. The scanning reduced projection optical system according to claim 4 or 5, wherein the array mask is installed on a mount including a θ axis to enable minute rotation adjustment around an optical axis.

7. The scanning reduced projection optical system according to any one of claims 1 to 6, wherein the multimode pulsed laser light is excimer laser light.

8. A laser processing apparatus that uses emitting multimode pulsed laser light toward irradiation targets on a substrate to induce a reaction,
wherein the laser processing apparatus comprising:

a laser apparatus configured to oscillate the multimode pulsed laser light;
the scanning reduced projection optical system according to any one of claims 1 to 6; and
a stage configured to hold the substrate, the stage having drive axes of at least an X axis and a Y axis.

9. A LIFT apparatus for mounting or retransfer, or both,

wherein the LIFT apparatus comprises the laser processing apparatus according to claim 8,
the substrate is a donor substrate having a surface on which the irradiation targets are located,
the LIFT apparatus emits the pulsed laser light from a back surface of the donor substrate toward the irradiation targets to selectively strip or separate the irradiation targets and subject the irradiation targets to LIFT onto a receptor substrate facing the donor substrate, and
the LIFT apparatus has a structure in which

the stage is a donor stage configured to hold the donor substrate in an orientation in which the back surface faces an incident side of the pulsed laser light,
the LIFT apparatus further comprises a receptor stage configured to hold the receptor substrate, the receptor stage having an X axis, a Y axis, a vertical Z axis, and a θ axis in an XY plane,
the scanning reduced projection optical system and the donor stage are installed on a first surface plate,
the receptor stage is installed on a second surface plate or a base surface plate, and
the first surface plate and the second surface plate are each independently installed on the base surface plate.

10. The LIFT apparatus according to claim 9, wherein a controller for the scanning mirror includes a function of controlling the scanning mirror for scanning an optical axis toward an opening on the photomask and controlling irradiation of the pulsed laser light, the opening being selected based on position information of the irradiation targets on the donor substrate and information on LIFT target positions onto the receptor substrate, the position information and the information on LIFT target positions being acquired in advance.

11. The LIFT apparatus according to claim 9 or 10, wherein the donor stage holds two or more donor substrates and uses the two or more donor substrates in a switchable manner.

12. The LIFT apparatus according to any one of claims 9 to 11, wherein the donor stage is suspended on a lower surface of the first surface plate.

13. The laser processing apparatus according to claim 8, wherein the laser apparatus is an excimer laser apparatus.

14. A LIFT method of performing LIFT of irradiation targets on a donor substrate onto a receptor substrate facing the donor substrate by using the LIFT apparatus according to any one of claims 9 to 12, comprising:

   an inspection step of acquiring position information D of the irradiation targets on the donor substrate and position information R that is LIFT target positions for the irradiation targets onto the receptor substrate;
   a division step of partitioning a region on the donor substrate into division areas D each having a predetermined size;
   a selection step of selecting a position of an irradiation target to be subjected to LIFT in a division area D, based on the position information D and the position information R;
   a transfer step of performing LIFT of the selected irradiation target in the division area D onto a division area R facing the division area D, by using laser light emitted through an opening of the photomask facing the position of the selected irradiation target; and
   a moving step of moving the donor substrate and/or the receptor substrate after the transfer step,
   wherein subsequently the transfer step and the moving step are repeated to perform mounting or retransfer for a whole region or a partial region of the receptor substrate.

15. The LIFT method according to claim 14, wherein a design mounting pitch of the irradiation targets on the donor substrate is 1/n times a design mounting pitch of the irradiation targets to be mounted on the receptor substrate, where n is an integer equal to or greater than one.

16. The LIFT method according to claim 15, wherein

   when there is an error between an actual mounting pitch of the irradiation targets calculated from the position information D and a design mounting pitch R calculated from the position information R,
   a movement amount of each substrate in the moving step is a movement amount that cancels an accumulated error amount according to the number of irradiation targets contained in the division area D.

17. The LIFT method according to claim 16, wherein

   when the accumulated error amount exceeds a given allowable range with an upper limit set to an interval between adjacent irradiation targets on the donor substrate,
   the division step reduces the division area D in size to a corrected division area D, and
   a movement amount of each substrate in the moving step is a movement amount that cancels error amounts accumulated in the corrected division area D.

18. The LIFT method according to claim 17, wherein a simulation program having the position information D, the position information R, the size of the division area D, and the allowable range as parameters determines a size of the corrected division area D, a combination of movement amounts of the stages, and order of the steps such that time required for mounting or retransfer over the entire receptor substrate is shortest, and causes execution of the steps.

19. A scanning reduced projection optical system for use in a laser processing apparatus that uses emitting laser light toward irradiation targets to induce a reaction,
   wherein the scanning reduced projection optical system comprises an infinity-corrected optical system, a scanning mirror, and a photomask.

20. A laser processing apparatus that uses emitting laser light toward irradiation targets to induce a reaction,

wherein the laser processing apparatus comprises a laser apparatus configured to oscillate the laser light, an infinity-corrected optical system, and a scanning mirror.

21. A LIFT apparatus for emitting laser light toward a donor substrate having irradiation targets to move the irradiation targets from the donor substrate to a receptor substrate,
    wherein the LIFT apparatus comprises a laser apparatus configured to oscillate the laser light, an infinity-corrected optical system, and a scanning mirror.

22. A laser processing method in which laser light is emitted toward irradiation targets to induce a reaction,
    wherein laser light is emitted toward the irradiation targets by using a scanning reduced projection optical system comprising an infinity-corrected optical system, a scanning mirror, and a photomask.

23. A LIFT method in which laser light is emitted toward a donor substrate having irradiation targets to move the irradiation targets from the donor substrate to a receptor substrate,
    wherein laser light is emitted toward the irradiation targets by using a scanning reduced projection optical system comprising an infinity-corrected optical system, a scanning mirror, and a photomask.

24. A method of manufacturing an irradiation target-mounted substrate in which laser light is emitted toward a donor substrate having irradiation targets to move the irradiation targets from the donor substrate to a receptor substrate,
    wherein laser light is emitted toward the irradiation targets by using a scanning reduced projection optical system comprising an infinity-corrected optical system, a scanning mirror, and a photomask.

25. The method of manufacturing an irradiation target-mounted substrate according to claim 24, wherein the irradiation targets are micro devices.

26. The method of manufacturing an irradiation target-mounted substrate according to claim 25, wherein the micro devices are micro LEDs.

27. The method of manufacturing an irradiation target-mounted substrate according to claim 25 or 26, wherein the micro devices are arranged in a matrix on the donor substrate.

28. The method of manufacturing an irradiation target-mounted substrate according to claim 24, wherein each of the irradiation targets is a film.

29. The method of manufacturing an irradiation target-mounted substrate according to claim 28, wherein the film is an electrically conductive film or an adhesive film.

30. The method of manufacturing an irradiation target-mounted substrate according to claim 28, wherein the film is an organic EL film.

31. A method of manufacturing a micro device-mounted substrate, the method comprising steps of:

    emitting laser light toward a first donor substrate having a film to move the film from the first donor substrate to a receptor substrate so as to obtain a film-mounted substrate; and
    emitting laser light toward a second donor substrate having a micro device to move the micro device from the second donor substrate onto the film of the film-mounted substrate,
    wherein laser light is emitted toward the film or the micro device by using a scanning reduced projection optical system comprising an infinity-corrected optical system, a scanning mirror, and a photomask.

32. A defective section-removing method in which laser light is emitted toward a defective section in a donor substrate having the defective section to remove the defective section from the donor substrate,
    wherein laser light is emitted toward the defective section by using a scanning reduced projection optical system comprising an infinity-corrected optical system, a scanning mirror, and a photomask.

33. A retransfer method in which laser light is emitted toward a donor substrate having irradiation targets to move the irradiation targets from the donor substrate to a receptor substrate,

    wherein the receptor substrate has a region in which the irradiation targets have been mounted in advance, and a defective region in which no irradiation target is mounted in a mounting target region, and laser light is emitted toward an irradiation target on the donor substrate by using a scanning reduced projection optical system comprising an infinity-corrected optical system, a scanning mirror, and a photomask so that the irradiation target is moved to the defective region in the receptor substrate.

34. A LIFT method in which laser light is emitted toward a donor substrate having irradiation targets to move the irradiation targets from the donor substrate to a receptor substrate,

wherein the irradiation targets on the donor substrate have a defective region, and laser light is emitted toward the irradiation targets excluding the defective region by using a scanning reduced projection optical system comprising an infinity-corrected optical system, a scanning mirror, and a photomask, so that the irradiation targets are moved to the receptor substrate.

35. A laser processing method in which laser light is emitted toward irradiation targets to induce a reaction, wherein the laser light is scanned by a scanning mirror so that the laser light forms an image onto a photomask as an image plane of an infinity-corrected optical system, and the laser light passing through the photomask is reduced and projected onto the irradiation targets.

36. A LIFT method in which laser light is emitted toward a donor substrate having irradiation targets to move the irradiation targets from the donor substrate to a receptor substrate, wherein the laser light is scanned by a scanning mirror so that the laser light forms an image onto a photomask as an image plane of an infinity-corrected optical system, and the laser light passing through the photomask is reduced and projected onto the irradiation targets.

37. A method of manufacturing an irradiation target-mounted substrate in which laser light is emitted toward a donor substrate having irradiation targets to move the irradiation targets from the donor substrate to a receptor substrate, wherein the laser light is scanned by a scanning mirror so that the laser light forms an image onto a photomask as an image plane of an infinity-corrected optical system, and the laser light passing through the photomask is reduced and projected onto the irradiation targets.

38. A scanning reduced projection optical system for use in a laser processing apparatus that uses emitting laser light toward irradiation targets to induce a reaction, wherein the scanning reduced projection optical system comprises a first lens array, a second lens array, a scanning mirror, and a photomask.

39. The scanning reduced projection optical system according to claim 38, wherein the first lens array or the second lens array comprises an array of lens elements.

40. The scanning reduced projection optical system according to claim 39, wherein the lens elements are of a fly eye type, a cylindrical type, or a spherical type.

41. The scanning reduced projection optical system according to any one of claims 38 to 40, wherein the first lens array or the second lens array is a combination of uniaxial cylindrical lenses at right angle.

42. The scanning reduced projection optical system according to any one of claims 38 to 41, wherein an array mask is arranged immediately before the first lens array.

43. The scanning reduced projection optical system according to any one of claims 38 to 42, wherein an array mask is arranged between the first lens array and the second lens array.

44. The scanning reduced projection optical system according to claim 42 or 43, wherein the array mask has an opening group.

45. The scanning reduced projection optical system according to claim 44, wherein openings forming the opening group are circular, elliptical, square, or rectangular.

46. The scanning reduced projection optical system according to claim 44 or 45, wherein openings forming the opening group each have a size smaller than a size of each lens element.

**47.** The scanning reduced projection optical system according to any one of claims 42 to 46, wherein the array mask has at least two kinds of opening groups.

**48.** The scanning reduced projection optical system according to claim 47, wherein the at least two kinds of opening groups are different from each other in size of openings forming each of the opening groups, shape of the openings, number of the openings, or arrangement of the openings.

**49.** A scanning reduced projection optical system for use in a laser processing apparatus that uses emitting laser light toward irradiation targets to induce a reaction,
wherein the scanning reduced projection optical system is telecentric only on an image side.

**50.** A defective section-removing method in which laser light is emitted toward a defective section in a donor substrate having the defective section to remove the defective section from the donor substrate,
wherein laser light is emitted toward the defective section using a scanning reduced projection optical system comprising a galvano scanner and a photomask.

**51.** The defective section-removing method according to claim 50, wherein the photomask has a circular, elliptical, square, or rectangular opening.

**52.** The defective section-removing method according to claim 50 or 51, wherein the photomask has a region in which openings are arranged in a matrix.

**53.** The defective section-removing method according to any one of claims 50 to 52, wherein the photomask has at least two kinds of opening groups.

**54.** The defective section-removing method according to claim 53, wherein the at least two kinds of opening groups are different from each other in size of openings forming each of the opening groups, shape of the openings, number of the openings, or arrangement of the openings.

**55.** A retransfer method in which laser light is emitted toward a donor substrate having irradiation targets to move the irradiation targets from the donor substrate to a receptor substrate,

wherein the receptor substrate has a region in which the irradiation targets have been mounted in advance, and a defective region in which no irradiation target is mounted in a mounting target region, and
laser light is emitted toward an irradiation target on the donor substrate by using a scanning reduced projection optical system comprising a galvano scanner and a photomask so that the irradiation target is moved to the defective region in the receptor substrate.

**56.** A LIFT method in which laser light is emitted toward a donor substrate having irradiation targets to move the irradiation targets from the donor substrate to a receptor substrate,

wherein the irradiation targets on the donor substrate have a defective region, and
laser light is emitted toward the irradiation targets excluding the defective region by using a scanning reduced projection optical system comprising a galvano scanner and a photomask so that the irradiation targets are moved to the receptor substrate.

[FIG. 1]

[FIG. 2]

[FIG. 3]

[FIG. 4]

[FIG. 5]

[FIG. 6A]

[FIG. 6B]

[FIG. 7]

[FIG. 8A]

[FIG. 8B]

[FIG. 9]

[FIG. 10A]

[FIG. 10B]

[FIG. 11]

[FIG. 12]

[FIG. 13]

[FIG. 14]

| | 33mm | |
|---|---|---|
| A 1 | B 1 | C 1 |
| A 2 | B 2 | C 2 |
| A 3 | B 3 | C 3 |
| A 4 | B 4 | C 4 |
| A 5 | B 5 | C 5 |
| A 6 | B 6 | C 6 |
| A 7 | B 7 | C 7 |
| A 8 | B 8 | C 8 |
| A 9 | B 9 | C 9 |

11mm

Y

X

[FIG. 15]

[FIG. 16]

[FIG. 17]

[FIG. 18]

## INTERNATIONAL SEARCH REPORT

International application No.

**PCT/JP2021/027082**

### A. CLASSIFICATION OF SUBJECT MATTER

***B23K 26/00***(2014.01)i
FI:  B23K26/00 B

According to International Patent Classification (IPC) or to both national classification and IPC

### B. FIELDS SEARCHED

Minimum documentation searched (classification system followed by classification symbols)

B23K26/00-26/70;H01L21/00-21/16;H01L27/32;H05B33/00-33/28;G03F7/20-7/24;9/00-9/02

Documentation searched other than minimum documentation to the extent that such documents are included in the fields searched

Published examined utility model applications of Japan 1922-1996
Published unexamined utility model applications of Japan 1971-2021
Registered utility model specifications of Japan 1996-2021
Published registered utility model applications of Japan 1994-2021

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| E, X | JP 2021-151666 A (SHIN-ETSU CHEMICAL CO., LTD.) 30 September 2021 (2021-09-30) paragraphs [0067]-[0112], fig. 1-18 | 1-33, 35-55 |
| X | JP 2015-534903 A (M-SOLV LTD.) 07 December 2015 (2015-12-07) paragraphs [0022]-[0054], fig. 1-12 | 19-20, 22, 35, 38-48 |
| Y | | 21, 23-31, 33-34, 36-37, 49 |
| A | | 1-18, 32, 50-56 |
| Y | WO 2019/244362 A1 (MARUBUN CO., LTD.) 26 December 2019 (2019-12-26) paragraphs [0058]-[0121], fig. 1-13C | 21, 23-31, 33-34, 36-37 |
| Y | JP 2006-309994 A (SONY CORP.) 09 November 2006 (2006-11-09) paragraphs [0021]-[0086], fig. 1-10 | 21, 23-31, 33-34, 36-37 |
| Y | JP 2008-110384 A (SUMITOMO ELECTRIC INDUSTRIES, LTD.) 15 May 2008 (2008-05-15) paragraph [0064], fig. 8 | 49 |

☑ Further documents are listed in the continuation of Box C.     ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 29 September 2021 | 12 October 2021 |

| Name and mailing address of the ISA/JP | Authorized officer |
|---|---|
| Japan Patent Office (ISA/JP) 3-4-3 Kasumigaseki, Chiyoda-ku, Tokyo 100-8915 Japan | |
| | Telephone No. |

Form PCT/ISA/210 (second sheet) (January 2015)

**INTERNATIONAL SEARCH REPORT**

| International application No. |
| --- |
| **PCT/JP2021/027082** |

**C.    DOCUMENTS CONSIDERED TO BE RELEVANT**

| Category* | Citation of document, with indication, where appropriate, of the relevant passages | Relevant to claim No. |
| --- | --- | --- |
| Y | JP 2018-27551 A (FORESIGHT TECHNO CO., LTD.) 22 February 2018 (2018-02-22) claim 6, paragraphs [0039]-[0055], fig. 7-10B | 49 |
| A | JP 2012-123127 A (HITACHI HIGH-TECHNOLOGIES CORP.) 28 June 2012 (2012-06-28) paragraphs [0024]-[0068], fig. 1-19 | 1-56 |

Form PCT/ISA/210 (second sheet) (January 2015)

**INTERNATIONAL SEARCH REPORT**
Information on patent family members

International application No.

**PCT/JP2021/027082**

| Patent document cited in search report | | | Publication date (day/month/year) | Patent family member(s) | | | Publication date (day/month/year) |
|---|---|---|---|---|---|---|---|
| JP | 2021-151666 | A | 30 September 2021 | (Family: none) | | | |
| JP | 2015-534903 | A | 07 December 2015 | US | 2015/0230341 | A1 | |
| | | | | paragraphs [0044]-[0076], fig. 1-12 | | | |
| | | | | GB | 2507542 | A | |
| | | | | WO | 2014/068274 | A1 | |
| | | | | CN | 104105569 | A | |
| | | | | KR | 10-2015-0067084 | A | |
| WO | 2019/244362 | A1 | 26 December 2019 | JP | 2020-4478 | A | |
| JP | 2006-309994 | A | 09 November 2006 | US | 2006/0243377 | A1 | |
| | | | | paragraphs [0025]-[0074], fig. 1-6C | | | |
| | | | | KR | 10-2006-0113456 | A | |
| | | | | CN | 1867215 | A | |
| JP | 2008-110384 | A | 15 May 2008 | (Family: none) | | | |
| JP | 2018-27551 | A | 22 February 2018 | (Family: none) | | | |
| JP | 2012-123127 | A | 28 June 2012 | (Family: none) | | | |

Form PCT/ISA/210 (patent family annex) (January 2015)

**REFERENCES CITED IN THE DESCRIPTION**

**Patent documents cited in the description**

- JP 2020004478 A
- JP 2006041500 A